# EUROPEAN PATENT APPLICATION

(11) **EP 4 607 590 A1**
(43) Date of publication of application: **27.08.2025**
(21) Application number: 24305306.3
(22) Date of filing: 26.02.2024
(51) Int. Cl.: H01L 23/522, H01L 23/64, H01L 23/66, H01L 23/498, H03H 1/00, H03H 7/01

(54) **RING-BASED MATCHING NETWORKS AND METHODS**

(71) Applicant: NXP USA, Inc., Austin TX 78735 (US)
(72) Inventor: Andrei, Cristian, 31023 Toulouse Cedex 1 (FR); Tesson, Olivier, 31023 Toulouse Cedex 1 (FR)
(74) Representative: Schmütz, Christian Klaus Johannes

(57) **Abstract**

An electronic device may include semiconductor wafer including a semiconductor substrate and multiple layers on the semiconductor substrate. The multiple layers may include metal layers and dielectric layers forming a circuit and an on-chip pad configured to receive a signal. The device may include a ring-based matching network and a wire trace. The network may include one or more rings arranged within the multiple layers and extending around the on-chip pad to provide a selected impedance compensation to the received signal to produce a compensated signal. Each ring may have a selected width and a selected spacing relative to one or more of the on-chip pad or another ring. The wire trace may be configured to couple the on-chip pad to the circuit to provide the compensated signal. In some embodiments, one of the rings may be connected to or may be capacitively coupled to the on-chip pad.

## Description

The present disclosure generally relates to impedance matching at an on-chip transition (electrical connection) of an integrated circuit, and more particularly to ring-based matching networks configured to provide impedance matching at on-chip transitions.

### BACKGROUND

Packaging connections, such as solder bumps, conductive pillars, and other on-chip transitions, may introduce a capacitive contribution to the signal path for electrical signals provided to the chip. Such capacitive contributions may degrade the received signal. While efforts are made during manufacturing to match the impedances at these transitions, advanced complementary metal-oxide semiconductor technologies used in conjunction with advanced packaging methodologies can make impedance matching (50-75 Ohms single-ended or 100-150 Ohms differential) very difficult to achieve.

### BRIEF DESCRIPTION OF THE DRAWINGS

The detailed description is set forth with reference to the accompanying figures. In the figures, the left-most digit(s) of a reference number identifies the figure in which the reference number first appears. The use of the same reference numbers in different figures and in the detailed description indicates similar or identical items or features.
FIG. 1A depicts a perspective view of an on-chip transition including a conductive pillar coupled to an on-chip conductive pad.
FIG. 1B depicts a cross-sectional view of a semiconductor substrate that includes an on-chip transition and a ring-based matching network to provide impedance compensation, in accordance with certain embodiments of the present disclosure.
FIG. 2 depicts a perspective view of an on-chip transition including a ring-based matching network, in accordance with one or more embodiments of the present disclosure.
FIG. 3 depicts a top view of the on-chip transition including the ring-based matching network of FIG. 2 and illustrating signal paths through the ring-based matching network, in accordance with one or more embodiments of the present disclosure.
FIG. 4 depicts top views of various on-chip transitions including one configuration without a ring-based matching network and multiple configurations with various ring-based matching networks, in accordance with one or more embodiments of the present disclosure.
FIG. 5 depicts a graph of the ratio of the capacitive impedance to the reference impedance for each of the configurations depicted in FIG. 4.
FIG. 6 depicts a diagram of a system including an on-chip transition with a programmable ring-based matching network and control circuitry to program the matching network, in accordance with one or more embodiments of the present disclosure.
FIG. 7 depicts a perspective view of an on-chip transition including an alternative embodiment of a capacitive ring-based matching network, in accordance with one or more embodiments of the present disclosure.
FIG. 8 depicts a top view of the on-chip transition of FIG. 7 including an on-chip inductor in series with the capacitive ring-based matching network, in accordance with one or more embodiments of the present disclosure.
FIG. 9 depicts a top view of the on-chip transition of FIG. 7 including multiple rings with a programmable inductor network, in accordance with one or more embodiments of the present disclosure.
FIG. 10 depicts a graph of the ratio of the capacitive impedance to the reference impedance for various configurations of the capacitive ring-based matching network, in accordance with one or more embodiments of the present disclosure.
FIG. 11 depicts a top view of an on-chip transition including another alternative embodiment of a ring-based matching network, in accordance with one or more embodiments of the present disclosure.
FIG. 12 depicts a top view of an on-chip transition including another alternative embodiment of a ring-based matching network, in accordance with one or more embodiments of the present disclosure.
FIG. 13 depicts a flow diagram of a method of generating a ring-based matching network, in accordance with one or more embodiments of the present disclosure.
FIG. 14 depicts a flow diagram of a method of generating a ring-based matching network using capacitively-coupled rings with on-chip inductors, in accordance with one or more embodiments of the present disclosure.
FIG. 15 depicts a flow diagram of a method of generating a ring-based matching network for one or more on-chip transitions, in accordance with one or more embodiments of the present disclosure.
FIG. 16 depicts a flow diagram of a method of programming a ring-based compensation network by selectively activating one or more switches, in accordance with one or more embodiments of the present disclosure.

While embodiments are described in this disclosure by way of example, those skilled in the art will recognize that the embodiments are not limited to the examples or figures described. Rather, the figures and detailed description thereto are not intended to limit embodiments to the form disclosed, but instead the intention is to cover all modifications, equivalents, and alternatives falling within the scope as defined by the appended claims. The headings used in this disclosure are for organizational purposes only and are not meant to limit the scope of the description or the claims.

As used herein, the term "ring" refers to a closed-loop structure that includes an interior diameter defining an open space and that has a shape that includes one or more sides. As used herein, the term "ring-shaped" or "ring-based" structure or matching network refers to a closed-loop structure that may take the form of a circle, an ellipse, or a polygon that corresponds to the shape of the on-chip pad with which the structure is associated. As used throughout this application, the word "may" is used in a permissive sense (in other words, the term "may" is intended to mean "having the potential to") instead of in a mandatory sense (as in "must"). Similarly, the terms "include," "including," and "includes" mean "including, but not limited to."

### DETAILED DESCRIPTION

Advanced CMOS technologies used in combination with advanced packaging methodologies may impact matching conditions at the edges of the technology process (50-75 Ohms single-ended, 100-150 Ohms differential-ended). Impedance matching with the CMOS and packaging methodologies alone may be very difficult to achieve due to capacitive contributions introduced by packaging connections (such as solder bumps, pillars, or other electrical transitions). To overcome such capacitive contributions, it is possible to add inductive contributions using narrow wire traces or in-situ resonators. The narrow wire traces may be difficult because the narrow width may be at the expense of losses, while in-situ resonators can be difficult to integrate. Embodiments of ring-based matching network solutions are described herein that can provide impedance matching for on-chip transitions without loss penalties.

Embodiments of ring-based matching networks and methods are described below that include a substrate including circuitry and including an on-chip pad with an associated ring-based matching network. The ring-based matching network may include one or more rings extending around the on-chip pad. In one or more embodiments, the one or more rings may be capacitively coupled to the on-chip pad and each of the one or more rings may be coupled to ground through an on-chip inductor to provide a selected impedance compensation. In some embodiments, the ring-based matching network may include one or more switches, where each switch is configured to selectively couple one of the on-chip inductors to one of the rings to prove a programmable inductor-capacitor (LC) resonator network.

In one or more embodiments, the one or more rings may be coupled to the on-chip pad by one or more interconnects (electrical conductors) to provide a selected impedance compensation. In some implementations, one or more of the one or more interconnects may be connected between the on-chip pad and the ring by a controllable switch to provide a programmable impedance compensation.

In one or more embodiments, the one or more rings may include at least one first ring that is capacitively coupled to the on-chip pad and at least one second ring that is coupled to the on-chip pad by one or more interconnects (conductors) and that is coupled to on-chip circuitry by a wire trace. Other embodiments are also possible.

In some embodiments, the ring-based matching network may enable impedance matching within a tuning range of plus or minus twenty percent (+/- 20%) with respect to the characteristic impedance, an improvement in insertion (return) losses of twenty decibels (-20dB) or greater at a selected frequency, or both. In some implementations, the ring-based matching network may be used in combination with programmable switches to provide trimming of the impedance matching during industrial testing to compensate for process spread.

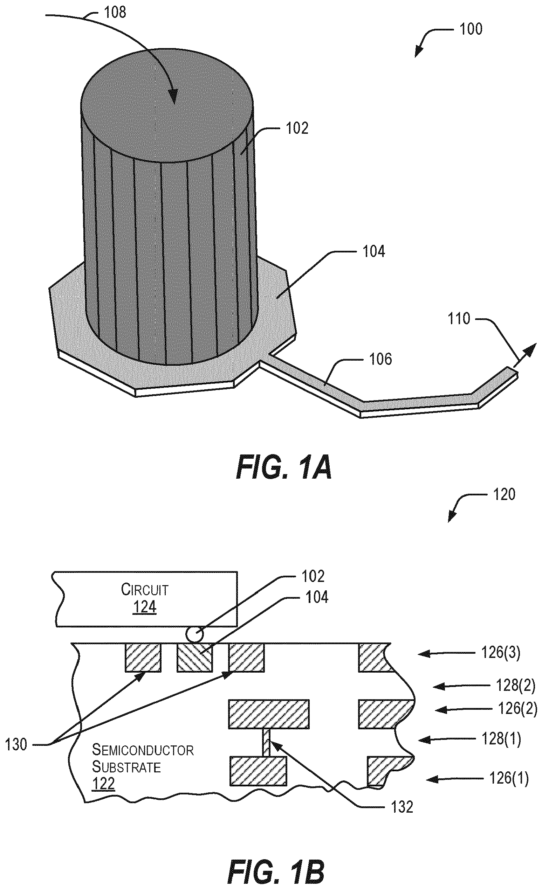

In the following discussion, it should be understood that on-chip transitions (signal inputs, and so on), such as a transition between an on-chip pad and one of a solder bump or pillar, may introduce impedance mismatches and may cause insertion (return) losses. An example of an on-chip transition is described below with respect to FIG. 1A.

FIG. 1A depicts a perspective view of an on-chip transition 100 including a conductive pillar 102 coupled to an on-chip conductive pad 104. The on-chip conductive pad 104 may be formed of a conductive metal material, which may be coupled to on-chip circuitry by a conductive trace 106. In an example, the on-chip conductive pad 104 may be formed from aluminum, copper, cobalt, gold, nickel, tungsten, or another conductive metal. While the illustrated example depicts a pillar 102, it should be understood that the on-chip pad 104 may be coupled to a solder bump, a pillar 102, or another electrical conductor. The transition from the pillar 102, solder bump, or other electrical conductor to the on-chip pad 104 may be capacitive, which may introduce impedance mismatches and return losses.

A received signal 108 from an external source may be conducted by the pillar 102 to the on-chip pad 104, which may provide an output signal 110 to on-chip circuitry through the wire trace 106. The impedance mismatches and return losses may cause the output signal 110 to be degraded relative to the received signal 108. During a design phase or during a chip testing operation, the characteristic impedance of the on-chip transition 100 may be determined and a ring-based matching network may be added to provide impedance compensation. An illustrative example of a ring-based matching network is described below with respect to FIG. 1B.

FIG. 1B depicts a cross-sectional view 120 of a semiconductor substrate 122 that includes an on-chip transition and a ring-based matching network 130 to provide impedance compensation, in accordance with certain embodiments of the present disclosure. In the illustrated example, the semiconductor substrate 122 may include a build-up portion including a plurality of metal layers 126 separated by dielectric layers 128. The semiconductor substrate 122 may include a first metal layer 126(1), a second metal layer 126(2), and a third metal layer 126(3), which are separated by a first dielectric layer 128(1) and a second dielectric layer 128(2). It should be understood that the semiconductor substrate 122 may include more layers or fewer layers depending on the embodiment. Additionally, metal vias or connections 132 may extend from one metal layer 126 to another through the dielectric 128. Other electrical connections may be established within a selected layer.

In this example, the semiconductor substrate 122 may include an on-chip pad 104 formed in the metal layer 126(3). The on-chip pad 104 may be coupled to a pillar (or solder bump) 102 that may be coupled to another circuit 124. To compensate for the characteristic impedance of the on-chip transition through the pillar 102 and the on-chip pad 104, the semiconductor substrate 122 may include a ring-based matching network, generally indicated at 130. In this example, a single ring may be formed around the on-chip pad 104 to provide a selected impedance compensation.

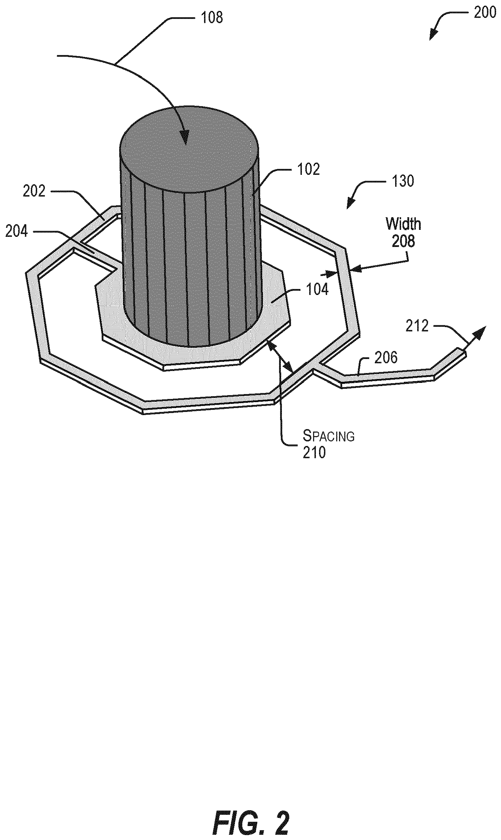

In some embodiments, the ring-based matching network 130 may include a ring that is coupled to the on-chip pad 104 by a conductive trace or interconnect. The ring may be coupled by a wire trace to on-chip circuitry formed by the build-up of the metal layers 126 and dielectric layers 128 to provide a compensated signal. In other embodiments, the ring-based matching network 130 may include one or more rings that are capacitively coupled to the on-chip pad 104, and the on-chip pad 104 may be coupled to the on-chip circuitry by a wire trace 106 to provide a compensated signal. In some embodiments, each ring of the one or more rings may be coupled to an on-chip inductor. In still other embodiments, the ring-based matching network 130 may include a first ring that is capacitively coupled to the on-chip pad 104 and a second ring that extends around the first ring and that is coupled to the on-chip pad 104 by a conductive trace or interconnect. The first ring may be coupled to an on-chip inductor, and the second ring may be coupled to on-chip circuitry via a wire trace to provide a compensated signal. In some embodiments, the on-chip pad 104 may be selectively coupled to a ring by activating one or more transistors. In some embodiments, the one or more rings may be selectively coupled to one or more on-chip inductors by selectively activating one or more transistors. An example of a ring-based matching network 130 provided by a ring that is coupled to the on-chip pad 104 by a conductive trace or interconnect is described below with respect to FIG. 2.

FIG. 2 depicts a perspective view of an on-chip transition 200 including a ring-based matching network 130, in accordance with one or more embodiments of the present disclosure. The on-chip transition 200 may include all the elements of the on-chip transition 100 of FIG. 1 and may include a conductive ring 202 extending around the on-chip pad 104. As previously discussed, the term "ring" refers to a closed-loop structure that includes an interior diameter defining an open space and that has a shape that includes one or more sides. As used herein, the term "ring-shaped" or "ring-based" structure or matching network refers to a closed-loop structure that may take the form of a circle, an ellipse, or a polygon that surrounds and is spaced apart from the on-chip pad 104. In some embodiments, the shape of the ring-based matching network 130 may correspond to the shape of the on-chip pad 104 around which the ring-based matching network 130 is formed.

In the illustrated example, the on-chip pad 104 may have an octagonal shape, and the ring 202 may also have an octagonal shape, matching that of the on-chip pad 104. The ring 202 may be separated from the on-chip pad 104 by a predetermined spacing, which may be filled with a dielectric material. The ring 202 may be coupled to the on-chip pad 104 by one or more interconnects 204. Each of the one or more interconnects 204 may be a low-impedance connector, such as a conductive wire trace extending between the conductive pad 104 and a selected portion of the ring 202.

Unlike the on-chip transition 100 in FIG. 1, the on-chip pad 104 may be coupled to on-chip circuitry through the ring 202. In this example, the on-chip pad 104 may be coupled to ring 202 by an interconnect 204, and the ring 202 may be coupled to the on-chip circuitry by a wire trace 206 to provide an impedance compensated signal 212. In the illustrated embodiment, the ring 202 and the interconnect 204 may provide inductive compensation for the on-chip transition 100. By compensating the characteristic impedance of the on-chip pad 104, the ring-based matching network 130 provided by the ring 202, the one or more interconnects 204, and the wire trace 206 may match the characteristic impedance, reducing return losses.

The ring 202 may have a selected width 206. The width 206 may be adjusted during manufacturing. The ring 202 may have a selected spacing 208 from the on-chip pad 104. The spacing or distance between the edge of the on-chip pad 104 and the inside diameter of the ring 208 may be adjusted during manufacturing. The position of the interconnect 204, the number of interconnects 204, the width of the ring 202, and the spacing 208 of the ring 202 relative to the on-chip pad 104 may be selected to provide a selected impedance compensation for the on-chip transition 200. In an example, by adjusting the position of the interconnect 204, the resistance of the signal path is adjusted because the length of the signal path is changed.

In this example, the pillar 102 may conduct a received signal 108 to the on-chip pad 104. An interconnect 204 couple the on-chip pad 104 to the ring 202, providing a conductive path for the electrical signal corresponding to the received signal 108 to travel from the on-chip pad 104 to the ring 202 and through the ring 202 to the wire trace 206, which may produce a compensated output signal 212 to on-chip circuitry (not shown).

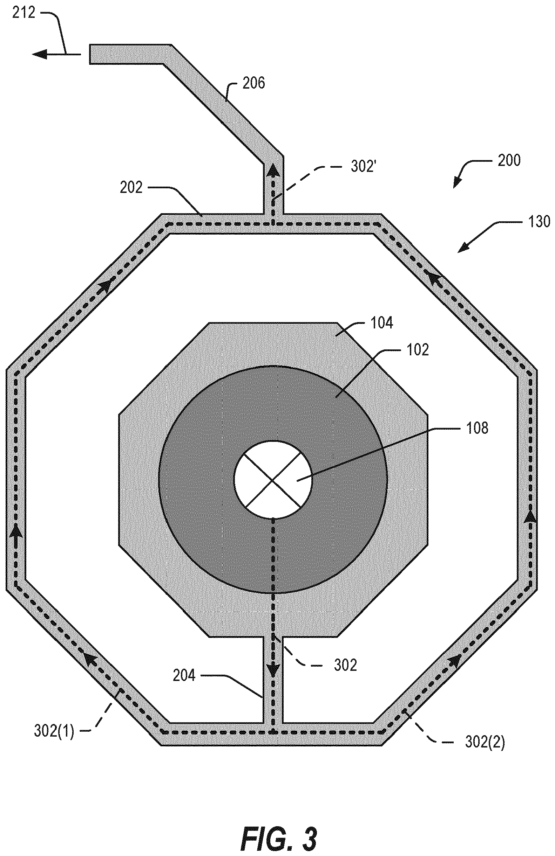

In the illustrated example, the ring 202 and the interconnect 204 comprise a ring-based matching network 130 configured to create a selected impedance compensation, producing a compensated output signal 212 with reduced signal degradation relative to an uncompensated signal. In some embodiments, the received signal may follow multiple signal paths between the interconnect 204 and the wire trace 206 through the ring 202. An illustrated example of the signal path is described below with respect to FIG. 3.

FIG. 3 depicts a top view 300 of the on-chip transition 200 including the ring-based matching network 130 of FIG. 2 and illustrating signal paths 302 through the ring-based matching network 130, in accordance with one or more embodiments of the present disclosure. In this example, the pillar 102 is coupled to the on-chip pad 104, which is coupled to the ring 202 by the interconnect 204. The ring 202 is coupled to on-chip circuitry through the wire trace 206.

In this example, an electrical signal corresponding to the received signal 108 may be conducted along a signal path 302 through the interconnect 204 to the ring 202. The electrical signal may then be divided between two signal paths 302(1) and 302(2) through the ring 202 before recombining as the electrical signal 302' at the wire trace 206. The electrical signal 302' may represent the compensated output signal 212. In this example, the signal paths 302 from the interconnect 204 to the wire trace 206 through the ring 202 are substantially equal, and the electrical signal may divide substantially equally between the two paths 302. In other embodiments, the lengths of the signal paths may be asymmetrical, and the asymmetry of the signal paths may contribute to the selected impedance compensation.

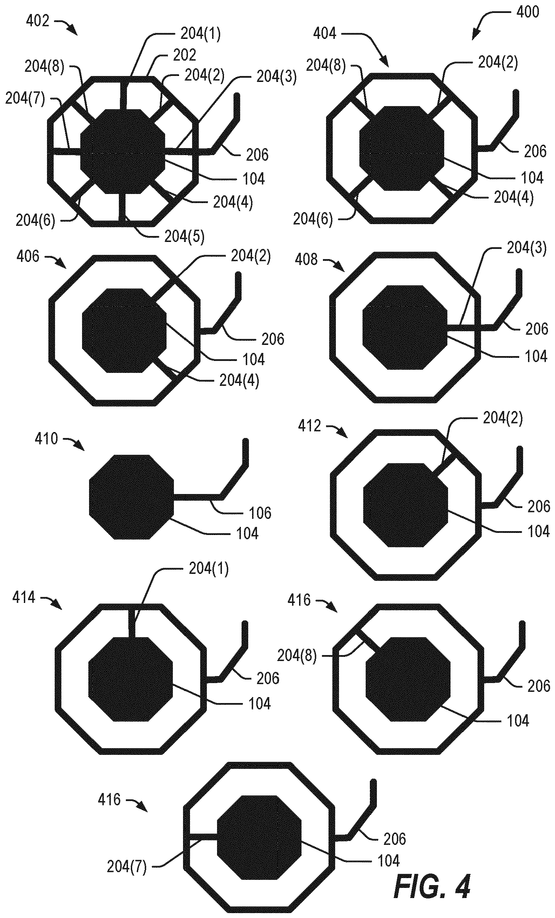

In the illustrated example of FIGs. 2 and 3, the ring-based matching network 130 includes a single ring 202 and a single interconnect 204, which is coupled to the ring 202 on a side that is opposite to the wire trace 206 (i.e., at an angle of one hundred eighty degrees (180°) around the ring 202 relative to a location where the wire trace 206 connects to the ring 202). The position of the interconnect 204 may be adjusted relative to a position of the wire trace 206 to alter the impedance compensation, in part, by altering the length of the signal paths 302 from the on-chip pad 104 to the wire trace 206. At high frequencies, the one or more interconnects 204 and the ring 202 may have a characteristic impedance that can be selected (tuned) to match the on-chip transition 100. In some embodiments, multiple interconnects 204 may be provided, and the electrical signal may follow multiple signal paths from the on-chip pad 104 to the wire trace 206 through one or more interconnects 204 and through the ring 202 to provide the selected impedance compensation. In some embodiments, the position of the one or more interconnects 204 relative to the wire trace 206 may be selected to provide a selected impedance compensation. Examples of different configurations of the ring-based matching network 130 are described below with respect to FIG. 4.

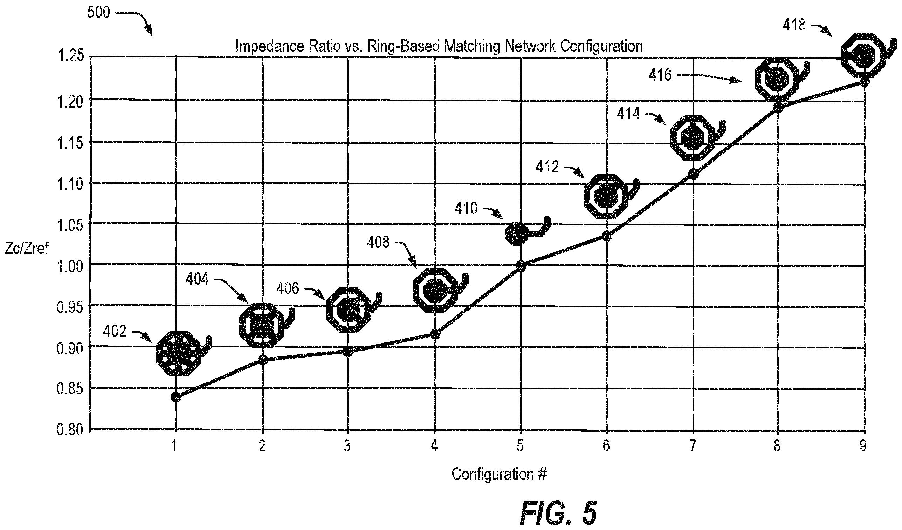

FIG. 4 depicts top views 400 of various on-chip transitions 100, 200 including a reference configuration 410 without a ring-based matching network 130 and multiple configurations 402, 404, 406, 408, 412, 414, 416, and 418 with various ring-based matching networks 130, in accordance with one or more embodiments of the present disclosure. Each of the configurations 402, 404, 406, 408, 412, 414, 416, and 418 may provide a different impedance compensation, as discussed in greater detail below with respect to FIG. 5.

In a first configuration 402, the on-chip pad 104 is coupled to the ring 202 by multiple interconnects 204(1), 204(2), 204(3), 204(4), 204(5), 204(6), 204(7), and 204(8), and the ring 202 is coupled to the wire trace 206, which may be coupled to on-chip circuitry (not shown). The interconnects 204 are spaced from one another by an equal distance and are arranged around the sides of the on-chip pad 104. In some embodiments, each interconnect 204 may extend at an angle of approximately forty-five degrees (45°) relative to the adjacent interconnects 204. In this example, the on-chip pad 102 is depicted as an octagonal shape, and an interconnect 204 extends from each side of the octagonal shape to a corresponding side of the ring 202. Each interconnect 204 provides a signal path from the on-chip pad 104 to the ring 202, which provides signal paths to the wire trace 206.

In the illustrated example, the interconnect 204(3) extends at an angle of zero degrees (0°) relative to the wire trace 206, while the interconnects 204(1), 204(7), and 204(5) extend at angles of ninety degrees (90°), one hundred eighty degrees (180°), and two hundred seventy degrees (270°), respectively. The interconnects 204(2), 204(8), 204(6), and 204(4) extend at angles of forty-five degrees (45°), one hundred thirty-five degrees (135°), two hundred fifteen degrees (215°), and three hundred five degrees (305°), respectively, relative to the position of the wire trace 206. Each of the interconnects 204 may provide a signal path from the on-chip pad 104 to the ring 212, and the signal may follow multiple paths from the on-chip pad 104, through the interconnects 204, and through the ring 202 to the wire trace 206, providing a selected impedance compensation.

In a second configuration 404, the on-chip pad 104 is coupled to the ring 202 by interconnects 204(2), 204(4), 204(6), and 204(8). The interconnects 204(2) and 204(6) are coupled to opposite sides of the on-chip pad 104, and the interconnects 204(4) and 204(8) are coupled to opposite sides of the on-chip pad 104. In some embodiments, each interconnect 204 may extend at an angle of approximately ninety degrees (90°) relative to the adjacent interconnects 204. In this example, none of the interconnects 204 are directly aligned with the wire trace 206. In particular, the interconnects 204(2), 204(8), 204(6), and 204(4) extend at angles of forty-five degrees (45°), one hundred thirty-five degrees (135°), two hundred fifteen degrees (215°), and three hundred five degrees (305°), respectively, relative to the position of the wire trace 206.

In the illustrated example, the interconnects 204 provide four signal paths between the on-chip pad 104 and the ring 202. The signal paths through the interconnects 204(2) and 204(4) are shorter than the signal paths through the interconnects 204(6) and 204(8).

In the third configuration 406, the on-chip pad 104 is coupled to the ring 202 by interconnects 204(2) and 204(4), which extend at an angle that is ninety degrees (90°) from one another and at an angle of approximately forty-five degrees (45°) relative to the wire trace 206. Each interconnect 204(2) and 204(4) may provide a signal path from the on-chip pad 104 to the ring 202.

In a fourth configuration 408, the on-chip pad 104 is coupled to the ring 202 by an interconnect 204(3) that extends at an angle of zero degrees (0°) relative to the wire trace 206. In this example, the interconnect 204(3) may provide a direct signal path through the ring 202 to the wire trace 206.

In a fifth configuration 410, the on-chip pad 104 is coupled directly to the wire trace 106, and the ring 202 is omitted. The fifth configuration 410 may represent a reference impedance that is not compensated by the ring-based matching network 130.

In a sixth configuration 412, the on-chip pad 104 is coupled to the ring 202 by an interconnect 204(2). The interconnect 204(2) extends at an angle of forty-five degrees (45°) relative to the wire trace 206. In this example, two current paths are provided through the ring 202 from the interconnect 204(2) to the wire trace 206. A first signal path from the interconnect 204(2) to the wire trace 206 has a length that is seven times longer than a length of the second signal path. The shorter signal path exhibits less impedance than the longer signal path.

In a seventh configuration 414, the on-chip pad 104 is coupled to the ring 202 by an interconnect 204(1). The interconnect 204(1) extends at an angle of ninety degrees (90°) relative to the wire trace 206. In this example, two current paths are provided through the ring 202 from the interconnect 204(1) to the wire trace 206. A first signal path from the interconnect 204(1) to the wire trace 206 has a length that is three times longer than a length of the second signal path. The shorter signal path exhibits less impedance than the longer signal path.

In an eighth configuration 416, the on-chip pad 104 is coupled to the ring 202 by an interconnect 204(8). The interconnect 204(8) extends at an angle of one hundred thirty-five degrees (135°) relative to the wire trace 206. In this example, two current paths are provided through the ring 202 from the interconnect 204(8) to the wire trace 206. A first signal path from the interconnect 204(8) to the wire trace 206 has a length that is two times longer than a length of the second signal path. The shorter signal path exhibits less impedance than the longer signal path.

In a ninth configuration 418, the on-chip pad 104 is coupled to the ring 202 by an interconnect 204(7). The interconnect 204(7) extends at an angle of one hundred eighty degrees (180°) relative to the wire trace 206. As indicated above with respect to FIG. 3, the ring 202 provides two signal paths 302(1) and 302(2) from the interconnect 204(7) through the ring 202 to the wire trace 206. Since the paths 302(1) and 302(2) are approximately the same length, the impedance provided by the interconnect 204 and the ring 202 is approximately the same through both paths 302(1) and 302(2).

Each of the configurations 402, 404, 406, 408, 412, 414, 416, and 418 may provide an impedance compensation that varies relative to the reference impedance provided by the configuration 410. In this example, the ring width 206 and the spacing 208 may be the same for each configuration 402, 404, 406, 408, 412, 414, 416, and 418, so the number of interconnects 204 and the arrangement of the one or more interconnects 204 determines the impedance compensation. A graph showing the ratio of the impedance compensation relative to the reference impedance is described below with respect to FIG. 5.

FIG. 5 depicts a graph 500 of the ratio of the capacitive impedance to the reference impedance for each of the configurations depicted in FIG. 4. In the illustrated example, the configurations 402, 404, 406, and 408 may provide impedance compensation that compensates for the capacitive contribution introduced by the on-chip transitions, while the configurations 412, 414, 416, and 418 may compensate for the inductive contribution introduced by the on-chip transitions. The configurations 412, 414, 416, and 418 provide impedance compensation that compensates for the inductive contribution introduced by the on-chip transitions.

In this example, the reference impedance may correspond to the fifth configuration 410, which does not include a ring-based matching network 130. The ratio of the compensated impedance (Zc) to the reference impedance (Zref) is one (1.00) because the fifth configuration 410 does not include a ring-based compensation network. As shown, configurations 402, 404, and 406 that have multiple interconnects 204 may reduce the input impedance by almost twenty percent (20%) for the first configuration 402. The first configuration 402 may include 204 that couples each side of the on-chip pad 104 to the ring 202.

The second configuration 404 may include four interconnects 204 that couple the on-chip pad 104 to the ring, where none of the interconnects 204 are aligned to the wire trace 206 and where each interconnect 204 extends at an angle of ninety degrees (90°) relative to adjacent interconnects 204. The second configuration 404 may reduce the input impedance by almost fifteen percent (15%).

The third configuration 406 may include two interconnects 204 that extend at an angle of ninety degrees (90°) relative to one another and that extend at an angle of forty-five degrees (45°) relative to the wire trace 206. The third configuration 406 may reduce the input impedance by approximately fourteen percent (14%).

The fourth configuration 408 may include a single interconnect 204 that couples the on-chip pad 104 to the ring 202 at a point that is adjacent to the wire trace 206. The interconnect 204 may be arranged to be almost a direct connection through the ring 202 to the wire trace 206. The fourth configuration 408 may reduce the input impedance by approximately twelve and a half percent (12.5%).

In general, for the first, second, third, and fourth configurations 402, 404, 406, and 408, the ring 202 may add a capacitance to ground. The one or more interconnects 204 may produce an inductive effect that does not compensate the capacitance of the on-chip transition, and thus the characteristic impedance is reduced relative to the reference impedance.

The sixth configuration 412 may include a single interconnect 204 that couples the on-chip pad 104 to the ring 202 and that extends at an angle of approximately forty-five degrees (45°) relative to the wire trace 206. The sixth configuration may provide an impedance compensation that provides an impedance ratio of approximately one (1).

The seventh configuration 414 may include a single interconnect 204 that couples the on-chip pad 104 to the ring 202 and that extends at an angle of approximately ninety degrees (90°) relative to the wire trace 206. The seventh configuration 414 may provide an impedance ratio of approximately 1.07.

The eighth configuration 416 may include a single interconnect 204 that couples the on-chip pad 104 to the ring 202 and that extends at an angle of approximately one hundred thirty-five degrees (135°) relative to the wire trace 206. The eighth configuration 416 may provide an impedance ratio of approximately 1. 16.

The ninth configuration 418 may include a single interconnect 204 that couples the on-chip pad 104 to the ring 202 and that extends at an angle of approximately one hundred eighty degrees (180°) relative to the wire trace 206. The ninth configuration 418 may provide an impedance ratio of approximately 1.18.

For the sixth, seventh, eighth, and ninth configurations 412, 414, 416, and 418, the interconnects 204 introduce an inductive effect that is greater than the capacitive contribution provided by the ring 202. This inductive effect may increase the characteristic impedance up to twenty percent (20%).

In the illustrated configurations 402, 404, 406, 408, 412, 414, 416, and 418 of FIGs. 4 and 5, the width of the ring 202 and the spacing between the on-chip pad 104 and the inside diameter of the ring 202 are constant, so the only variables determining the impedance compensation are the number of interconnects 204 and the position of the one or more interconnects 204 relative to the wire trace 206.

It is possible to further refine the impedance compensation by altering one or more of the width 206 or the spacing 208 of the ring 202 (shown in FIG. 2). In an example, the inductive contribution of the ring 202 may be increased by decreasing the width of the ring 202. In general, a wire with reduced width exhibits larger inductance per unit length than a wire with a relatively larger width.

In another example, depending on the available real estate of the circuit wafer, the diameter of the ring 202 may be adjusted to increase the spacing 208 between the edge of the on-chip pad 104 and the inside edge of the ring 202, which increased spacing 208 may increase the inductance provided by the ring 202 relative to a ring 202 with a smaller spacing.

In one or more implementations, the ring-based matching network 130 may be configured to provide a selected impedance compensation. In an example, the characteristic impedance of the on-chip transition 100 may be determined, and the selected impedance compensation may be provided by providing a ring 202 having a selected width, a selected spacing, and a selected number and position of one or more interconnects 204 relative to the wire trace 206.

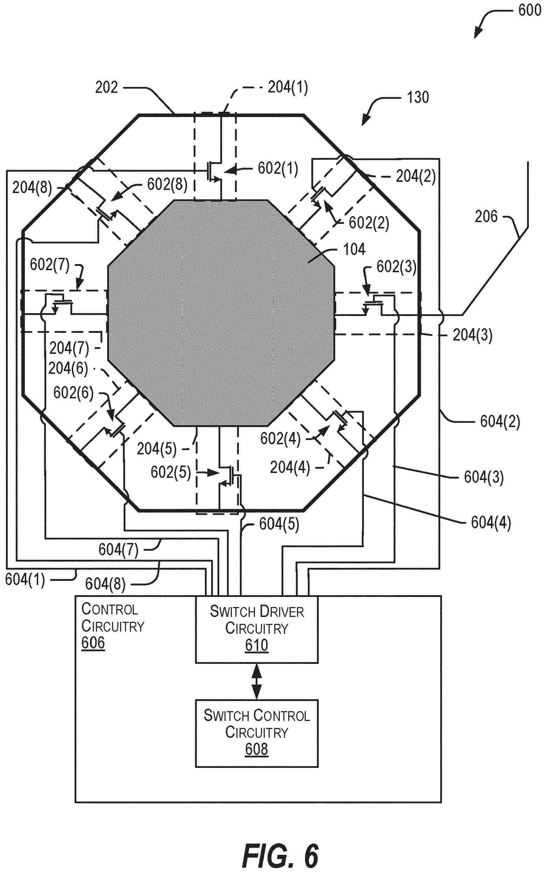

In one or more embodiments, electrical characteristics of the on-chip transition 100 may be determined. After determining the electrical characteristics, the ring-based matching network 130 may be selected from one of the configurations and optionally tuned by adjusting one or more of the width 206 or the spacing 208 of the ring 202 to provide a selected impedance compensation. Then, a circuit layout may be determined that includes the selected one of the configurations and optional tuning parameters. In other embodiments, the number and position of the interconnects 204 may be programmable, for example, by selectively activating one or more switches to close a connection between the on-chip pad 104 and the ring 202. In an example, the interconnects 204 may be programmable (digitally controlled) during industrial testing operations to compensate process spread (chip, package, or both) impacting insertion losses. An example of a ring-based matching network 130 with programmable interconnects is described below with respect to FIG. 6.

FIG. 6 depicts a diagram of a system 600 including an on-chip transition with a programmable ring-based matching network 130 and control circuitry 606 to program the matching network 130, in accordance with one or more embodiments of the present disclosure. The system 600 may include an on-chip pad 104, which may be coupled to a solder bump or pillar 102 to provide an on-chip transition. In this example, the on-chip pad 104 has an octagon shape.

The ring-based matching network 130 may include a ring 202 that extends around the on-chip pad 104. In some implementations, the ring 202 may have the same shape as the on-chip pad 104. The ring 202 may be spaced apart from the on-chip pad 104 by a selected spacing 210 and may have a selected width 208 (in FIG. 2). The ring-based matching network 130 may include a plurality of switches, such as metal oxide semiconductor field-effect transistors (MOSFETs) 602. Each MOSFET 602 may be independently controlled to selectively connect the on-chip pad 104 to the ring 202 to form one or more interconnects 204.

Each MOSFET 602 may include a drain coupled to the ring 202, a source coupled to the on-chip pad 104, and a gate. The system 600 may include control circuitry 606 including include switch control circuitry 608, which may be coupled to switch driver circuitry 610. The switch driver circuitry 610 may be independently coupled to the gate of each of the MOSFETs 602.

In an example, the control circuitry 606 may apply a control signal to the gate of the transistor 602(1), which may connect the on-chip pad 104 to the ring 202 via the interconnect 204(1). By selectively activating a transistor 602, the corresponding interconnect 204 is connected between the on-chip pad 104 and the ring 202.

In some embodiments, in response to determining a characteristic impedance of the on-chip transition, the control circuitry 606 may be configured to selectively activate one or more of the transistors 602 to provide a selected configuration, such as one of the configurations 402, 404, 406, 408, 412, 414, 416, or 418 shown in FIG. 4. For example, to provide the first configuration 402 in FIG. 4, the control circuitry 606 may apply a control signal to each gate of the plurality of MOSFETs 602 to couple the ring 202 to the on-chip pad 104 through each of the MOSFETs 602. To provide the second configuration 404 in FIG. 4, the control circuitry 606 may apply a control signal to the gates of the MOSFETs 602(2), 602(4), 602(6), and 602(8) to couple the ring 202 to the on-chip pad 104.

The third configuration 406 in FIG. 4 may be achieved by using the control circuitry 606 to apply control signals to the gates of the MOSFETs 602(2) and 602(4). The fourth configuration 408 in FIG. 4 may be achieved by applying a control signal to the gate of the MOSFET 602(1). The sixth configuration 412 in FIG. 4 may be achieved by applying a control signal to gate of the MOSFET 602(2). The seventh configuration 414 in FIG. 4 may be achieved by applying a control signal to the gate of the MOSFET 602(1). The eight configuration 416 may be achieved by applying a control signal to the gate of the MOSFET 602(8), and the ninth configuration 418 may be achieved by applying a control signal to the gate of the MOSFET 602(7).

In the illustrated example, the MOSFETs 602 may be field-programmable such that application of the control signal may permanently configure the MOSFET 602. In an example, the MOSFETs 602 may be selectively configured during industrial testing to compensate process spread (chip, package, or both) impacting insertion losses. In this example, the interconnects 204 are programmable by selectively activating one or more of the transistors 602.

It should be appreciated that the configurations 402, 404, 406, 408, 412, 414, 416, and 418 in FIG. 4 represent illustrative examples, other configurations are also possible. For example, in an illustrative example, the control circuitry 606 may apply a control signal to the MOSFETs 602(2) and 602(6), providing two connections between the on-chip pad 104 and the ring 202 that are asymmetric relative to the wire trace 206. In another example, the control circuitry 606 may activate the MOSFETs 602(4) and 602(1), providing two connections between the on-chip pad 104 and the ring 202 that are again asymmetric relative to the wire trace 206.

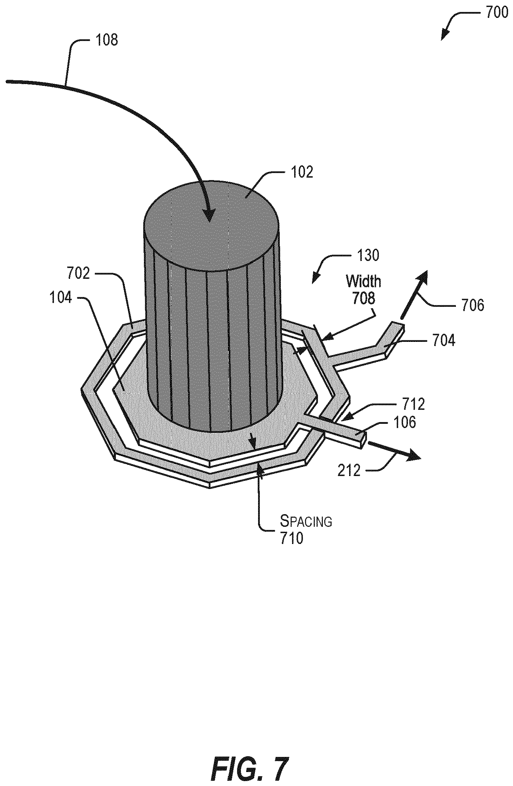

While the above examples of FIGs. 2-6 depicted embodiments of ring-based matching networks that include a single ring 202 that is electrically connected to the on-chip pad 104 by one or more interconnects 204, the ring-based matching network 130 may also utilize capacitive coupling between the on-chip pad 104 and one or more rings 202. An example of a ring-based matching network 130 that utilizes capacitive coupling is described below with respect to FIG. 7.

FIG. 7 depicts a perspective view of an on-chip transition 700 including an alternative embodiment of a capacitive ring-based matching network 130, in accordance with one or more embodiments of the present disclosure. In the illustrated example, a pillar 102 is coupled to an on-chip pad 104, which is coupled to on-chip circuitry (not shown) by a wire trace 106. The on-chip pad 104 is capacitively coupled to a ring 702 that surrounds the on-chip pad 104. The width 708 and spacing 710 of the ring 702 may be selected to provide a selected impedance compensation.

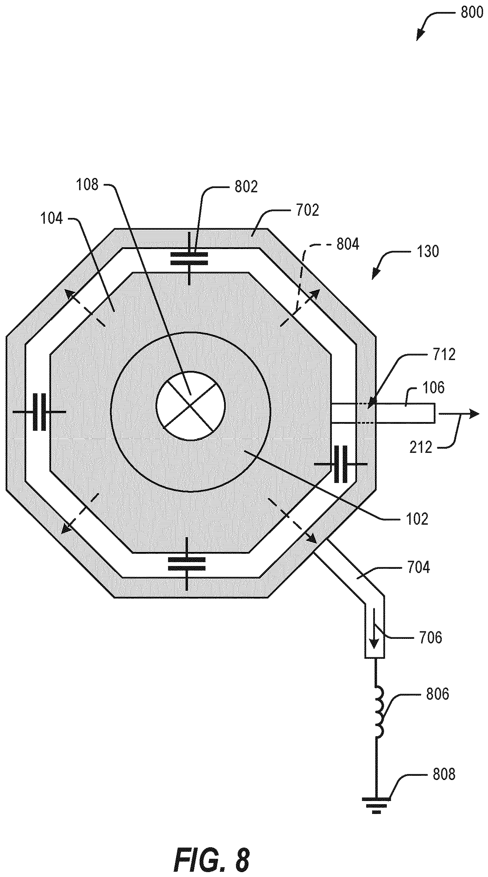

In the illustrated example, compensation for capacitive behavior of the transition from the pillar 102 to the on-chip pad 104 may be compensated through the ring 702 around the on-chip pad 104. In some embodiments, the ring 702 may be coupled to a wire trace 702, which may couple the ring 702 to an on-chip inductor 808 (shown in FIG. 8).

As shown, the ring 702 is not connected to the on-chip pad 104. In this example, the ring 702 may be continuous. The discontinuity depicted in FIG. 7 is for illustrative purposes only, showing that the wire trace 106 does not connect the on-chip pad 104 to the ring 702. In this example, a conductive trace may be provided in a layer that is above or below the layer of the chip pad 104 to connect the ring 702 on either side of the wire trace 106. Alternatively, the wire trace 106 may extend in a layer of the build-up on a semiconductor substrate that is below or above the ring 702.

The ring 702 may be coupled to a wire trace 706, which may be coupled to electrical ground 808 through an on-chip inductor 806. The on-chip inductor 806 in series with the ring 702 provides an impedance compensation for the on-chip transition 700. In this example, the
A signal 108 (in FIG. 1) may be received at the on-chip pad 104 from the pillar (or solder bump) 102. The on-chip pad 104 is capacitively coupled to the ring 702, which provides a resonator or capacitive compensation to the received signal 108 so that the output signal from the on-chip pad 104 via the wire trace 106 is a compensated signal 212.

It should be understood that the ring 702 and the on-chip pad 104 are capacitively coupled about the periphery of the on-chip pad 104. A top view of the on-chip transition 700 is described below with respect to FIG. 8 that shows the capacitive coupling of the on-chip pad 104 and the ring 702.

FIG. 8 depicts a top view 800 of the on-chip transition 700 of FIG. 7 including an on-chip inductor 806 in series with the capacitive ring-based matching network 130, in accordance with one or more embodiments of the present disclosure. The on-chip transition 700 includes the pillar (or solder bump) 102 and the on-chip pad 104, which is coupled to on-chip circuitry (not shown) by the wire trace 106. The capacitive ring-based matching network 130 includes a ring 702 having a selected width 708 and a selected spacing 710 (shown in FIG. 7). The wire trace 706 may continue under or over the ring 702 at a different layer of the circuit. The wire trace 706 is shown in phantom at 712 to indicate that it continues above or below the ring 702.

The ring 702 is capacitively coupled to the on-chip pad as indicated at 802. As previously indicated, the ring 702 is spaced apart from the on-chip pad 104 and separated from the on-chip pad by a dielectric material. The ring 702 is coupled to a wire trace 704 that is coupled to a first terminal of an inductor 806, which has a second terminal coupled to ground 808 (or to an on-chip negative voltage (VSS). The ring 702 in combination with the path to ground 808 through the inductor 806 may provide inductive compensation for the on-chip transition 700. In some embodiments, high frequency signal components may pass from the on-chip pad 104 through the dielectric to the ring 702, as indicated by the dashed arrows 804. The ring 702 and the on-chip inductor 806 may form a resonator that may provide compensation for the on-chip transition 700.

It should be appreciated that the effectiveness of the impedance compensation provided by the ring 702 depends on the capacitive coupling of the ring 702 to the on-chip pad 104. In some embodiments, the capacitive coupling can be adjusted by modifying one or more of the width 708 of the ring 702 or the spacing 710 of the ring 702 relative to the on-chip pad 104. In some embodiments, additional rings 702 may be added. In one or more embodiments, each ring 702 may be spaced apart from adjacent rings 702 by the same or different spacing and may have the same or different widths. In some embodiments, each ring 702 may be coupled to ground or to a negative voltage (VSS) by an inductor 806. In some embodiments, the rings 702 may be coupled to one another and may be coupled to ground or to a negative voltage (VSS) by a shared inductor 806.

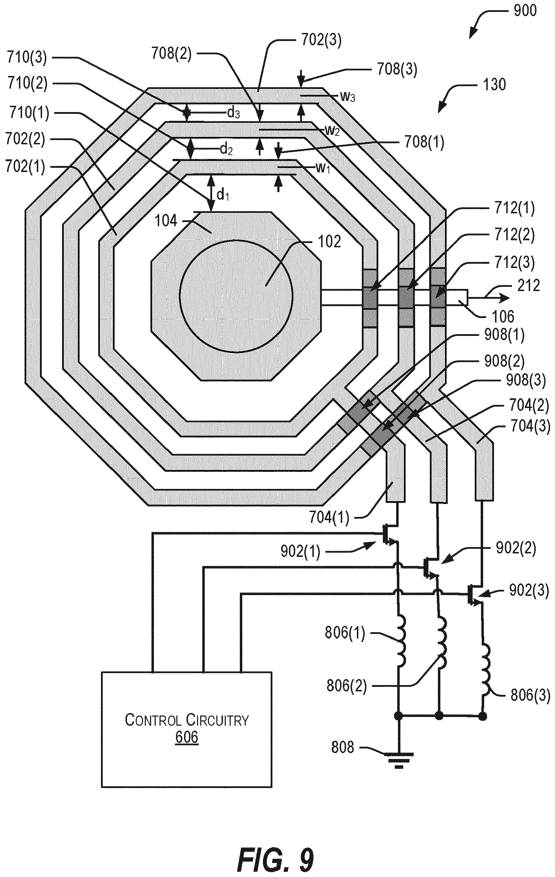

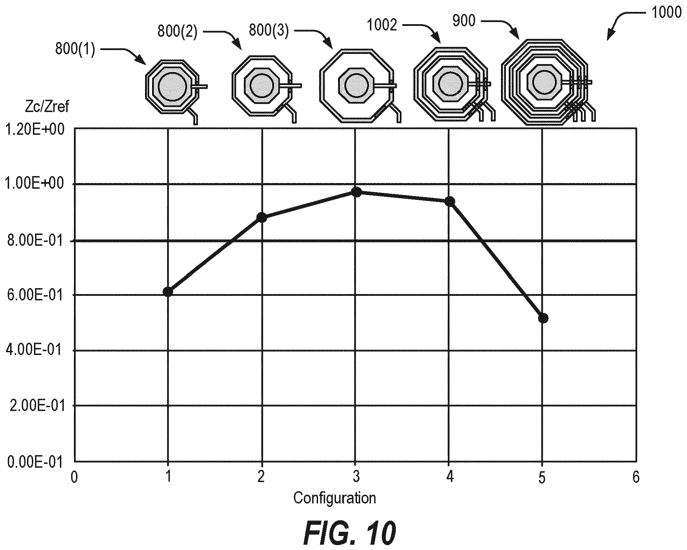

In some embodiments, the amount of capacitive coupling may limit the range (lowest value) of the impedance that might be compensated. For example, with three rings (as shown in FIGs. 9 and 10), the impedance compensation (Zc) may be compensated starting with approximately fifty percent (50%). The length of the inductor 806, the number of windings of the inductor 806, the position of the inductor 806 along a length of the wire trace 706, or other parameters may be adjusted to tune the inductance, which may compensate the shift provided by the impedance compensation with respect to a reference impedance, which may be provided by the on-chip transition 100 without a ring 202 or 702.

In some embodiments, the capacitive coupling between the on-chip pad 104 and the ring 702 may limit the frequency range of the on-chip transition 700. A relatively low capacitive coupling may enable tuning of a higher frequency range than a relatively high capacitive coupling will allow. As previously indicated, high frequency components of the received signal 108 may pass through the capacitive coupling from the on-chip pad 104 to the ring 702 and to ground through the inductor 806. In such a case, the ring 702 operates as a filter to remove components of the received signal 108 that are above a threshold frequency. The amount of the capacitive coupling between the ring 702 and the on-chip pad 104 (as determined by the width 706 and spacing 708 of the ring 702) may determine the threshold frequency.

As indicated above, in one or more embodiments, more than one ring 702 may be provided to produce a selected impedance compensation. An example of an embodiment that includes multiple rings 702 is described below with respect to FIG. 9.

FIG. 9 depicts a top view 900 of the on-chip transition 700 of FIG. 7 including multiple rings 702 with a programmable inductor network, in accordance with one or more embodiments of the present disclosure. In the illustrated example, the on-chip transition 700 includes the pillar 102 coupled to the on-chip pad 104, which is coupled to on-chip circuitry (not shown) by the wire trace 106. The on-chip pad 104 may transfer the received signal 108 as the compensated signal 212 via the wire trace 106.

The impedance compensation for producing the compensated signal 212 is provided by a ring-based matching network 130 comprised of a first ring 702(1), a second ring 702(2), and a third ring 702(3). The first ring 702(1) has a width (wi) 708(1) and is spaced apart from the on-chip pad 104 by a spacing (d₁) 710(1). The second ring 702(2) has a width (w₂) 708(2) and is spaced apart from the first ring 702(1) by a spacing (d₂) 710(2). The third ring 702(3) has a width (w₃) 708(3) and is spaced apart from the second ring 702(2) by a spacing (d₃) 710(3). In one or more embodiments, the first width 708(1), the second width 708(2), and the third width 708(3) may be the same or may be different. In one or more embodiments, the first spacing 710(1), the second spacing 710(2), and the third spacing 710(3) may be same or may be different.

The first ring 702(1) may be coupled to a first wire trace 704(1), which may pass over or under the second ring 702(2) at 908(1) and the third ring 703(3) at 908(2). The second ring 702(2) may be coupled to a second wire trace 704(2), which may pass over or under the third ring 702(3) at 908(3). The third ring 702(3) may be coupled to a third wire trace 704(3).

The programmable inductor network may include a plurality of switches. Each switch may be selectively activated to couple one of the wire traces 704 to a first terminal of an inductor 806, which has a second terminal coupled to ground 808 or to a negative supply voltage (VSS). In some embodiments, the switches may be implemented as metal oxide semiconductor field effect transistor (MOSFET).

A first MOSFET 902(1) may include a drain coupled to the first wire trace 704(1), a gate coupled to control circuitry 606, and a source coupled to a first terminal of a first inductor 806(1). The first inductor 806(1) may have a second terminal coupled to ground 808 or to the negative supply voltage (VSS).

A second MOSFET 902(2) may include a drain coupled to the second wire trace 704(2), a gate coupled to control circuitry 606, and a source coupled to a first terminal of a second inductor 806(2). The second inductor 806(2) may have a second terminal coupled to ground 808 or to the negative supply voltage (VSS).

A third MOSFET 902(3) may include a drain coupled to the third wire trace 704(3), a gate coupled to control circuitry 606, and a source coupled to a first terminal of a third inductor 806(3). The third inductor 806(3) may have a second terminal coupled to ground 808 or to the negative supply voltage (VSS).

In one or more embodiments, the MOSFETs 902 may be programmable (digitally controlled) during industrial testing operations to compensate process spread (chip, package, or both) impacting insertion losses. The MOSFETs 902 may be configured to couple one or more of the rings 702 to a corresponding one or more of the inductors 806 to tune the impedance compensation.

In the illustrated example, the capacitive coupling of each ring 702 to the on-chip pad 104 and to one or more adjacent rings 702 in conjunction with one or more activated transistors 902 may provide a selected impedance compensation for the received signal 108 to produce the compensated signal 212. An example of different compensations provided by the ring-based matching network 130 is described below with respect to FIG. 10.

FIG. 10 depicts a graph 1000 of the ratio of the capacitive impedance to the reference impedance for various configurations of the capacitive ring-based matching network 130, in accordance with one or more embodiments of the present disclosure. The graph 1000 depicts the ratio for five configurations of the ring-based matching network 130.

In first configuration 800(1), the on-chip pad 104 is capacitively coupled to a ring 702, which may be coupled to ground through an inductor. The ring 702 has a selected spacing (d) 710, a selected width (w) 708, and a selected inductor 806 to provide that is approximately forty percent (40%) less than the reference impedance (Z_{ref}).

The second configuration 800(2) has the same elements as the first configuration 800(1), but the selected spacing (d) 710 and the selected width (w) 708 may be adjusted relative to the first configuration. In the illustrated example, the selected spacing (d) 710 is greater than in the first configuration 800(1). Assuming the width (w) 708 and the inductor 806 are the same as in the first configuration 800(1), the increased spacing (d) 710 reduces the impedance compensation such that the ratio is about twelve percent (12%) less than the reference impedance (Z_{ref}).

The third configuration 800(3) has the same elements as the first and second configurations 800(1) and 800(2), but the selected spacing (d) 710 is greater than the spacing (d) 710 of either of the first configuration 800(1) or the second configuration 800(2). The increased spacing between the ring 700 and the on-chip pad 104 reduced the capacitive coupling such that the impedance compensation ratio is about three percent (3%) less than the reference impedance (Z_{ref}).

In a fourth configuration 1002, the ring-based matching network 130 includes a first ring 702(1) and a second ring 702(2). The first ring 702(1) has a first width (wi) 708(1) and is spaced apart from the on-chip pad 104 by a first spacing (d₁) 710(1). The second ring 708(2) has a second width (w₂) 708(2) and is spaced apart from the first ring 702(1) by a second spacing (d₂) 710(2). In the illustrated example, the first spacing 710(1) may be greater than the second spacing 710(2). The first width 708(1) may be approximately the same as the second width 708(2). Each ring 702 may be coupled to a respective on-chip inductor 806. The resulting impedance compensation is approximately four percent (4%) less than the reference impedance (Z_{ref}).

In a fifth configuration 900, the ring-based matching network 130 includes a first ring 702(1), a second ring 702(2), and a third ring 702(3). The first ring 702(1) has a first width (wi) 708(1) and is spaced apart from the on-chip pad 104 by a first spacing (d₁) 710(1). The second ring 708(2) has a second width (w₂) 708(2) and is spaced apart from the first ring 702(1) by a second spacing (d₂) 710(2). The third ring 702(3) has a third width (w₃) 708(3) and is spaced apart from the second ring 702(2) by a third spacing (d₃) 710(3). In some embodiments, the first spacing 710(1), the second spacing 710(2), and the third spacing 710(3) may be the same or may be different. In some embodiments, the first width 708(1), the second width 708(2), and the third width 708(3) may be the same or may be different. Each ring 702 may be coupled to a respective on-chip inductor 806. The fifth configuration may provide an impedance compensation that is approximately fifty percent (50%) less than the reference impedance (Z_{ref}).

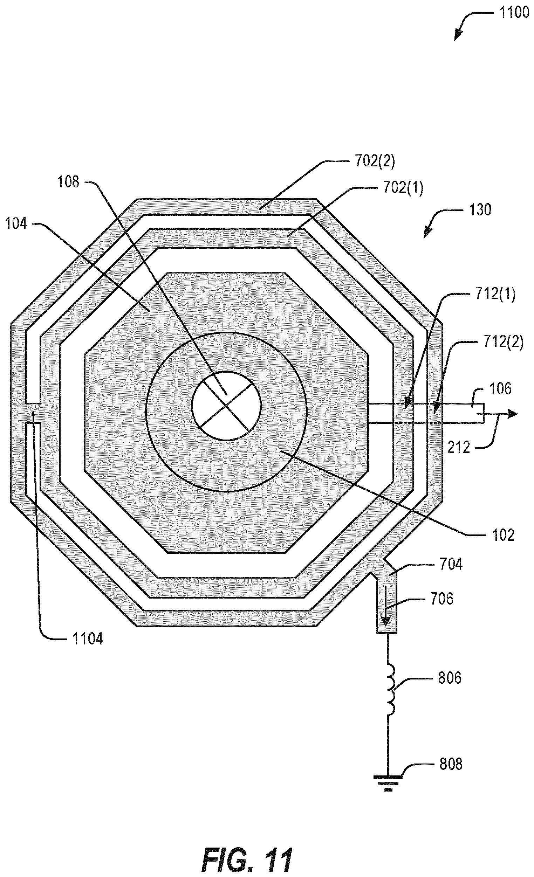

As previously indicated, adding rings 702, each of which may be in series with an inductor 806, adjusting the width 708, adjusting the spacing 710, and tuning the inductor 806 may provide a selected impedance compensation. The configurations 800, 1002, and 900 in FIG. 10 are provided for illustrative purposes and are not intended to be limiting. In some embodiments, multiple rings 702 may be provided, which may be coupled to one another and which may be coupled to a series inductor 806 that is shared by the rings 702. An example of such a configuration is described below with respect to FIG. 11.

FIG. 11 depicts a top view 1100 of an on-chip transition 700 of FIG. 7 and including another alternative embodiment of a ring-based matching network 130, in accordance with one or more embodiments of the present disclosure. In this example, the ring-based matching network 130 may include a first ring 702(1) and a second ring 702(2). The first ring 702(1) may have a first width (wi) 708(1) and may be spaced apart from the on-chip pad 104 by a first spacing (d₁) 710(1). The second ring 702(2) may have a second width (w₂) 708(2) and may be spaced apart from the first ring 702(1) by a second spacing (d₂) 710(2). The first width (wi) 708(1) and the second width (w₂) 708(2) may be the same or different. In this example, the first width 708(1) is greater than the second width 708(2). The first spacing (d₁) 710(1) and the second spacing (d₂) 710(2) may be the same or different. In this example, the first spacing 710(1) is greater than the second spacing 710(2).

In this example, the first ring 702(1) may be coupled to the second ring 702(2) by an interconnect 1104. The interconnect 1104 may be an electrically conductive trace that electrically connects the first ring 702(1) to the second ring 702(2). The second ring 702(2) is coupled by a wire trace 704 to a first terminal of an on-chip inductor 806, which has a second terminal coupled to ground 808 or to a negative supply voltage (VSS).

In the illustrated example, the position of the interconnect 1104 may be selected to provide a selected resistance through the ring 702. As indicated above, the width 708 of the ring 702, the spacing of the ring 702, the number of rings 702, and the inductor 806 represent parameters that may be selected to provide a desired impedance compensation. The position of the interconnect 1104 may provide an additional tuning parameter for the impedance compensation provided by the ring-based matching network 130.

While the example of the interconnect 1104 in FIG. 11 depicts a single conductive wire trace, in other implementations, one or more switches, such as the MOSFETs 602 in FIG. 6 may be arranged between the rings 702(1) and 702(2), and one or more of the switches may be activated to form interconnects 1104 at selected locations. In such an implementation, the location or locations of one or more interconnects 1104 may be selected to provide a desired impedance compensation.

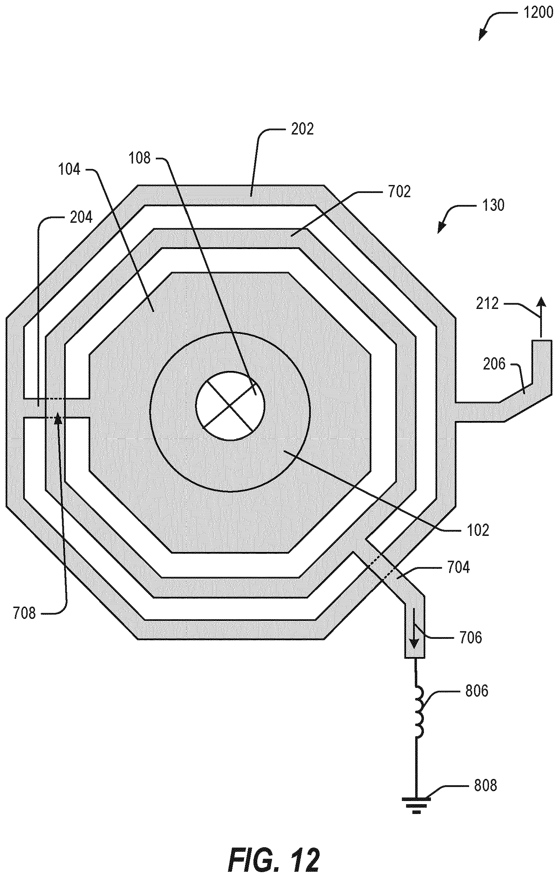

FIG. 12 depicts a top view of an on-chip transition 1200 including another alternative embodiment of a ring-based matching network 130, in accordance with one or more embodiments of the present disclosure. In this example, the on-chip transition 1200 includes the on-chip pad 104 coupled to the pillar (solder bump) 102 and coupled to a ring 202 by an interconnect 204. The ring 202 is coupled to on-chip circuitry (not shown) by a wire trace 206 to provide a compensated signal 212.

The on-chip transition 1200 may include a ring 702 between the ring 202 and the on-chip pad 104. The ring 702 may be capacitively coupled to the on-chip pad 104 and may be coupled to a wire trace 704, which may be coupled to a first terminal of an inductor 806. The inductor 806 may include a second terminal coupled to ground 808 or to a negative supply voltage (VSS).

In this example, the ring 702 may be positioned between the on-chip pad 104 and the ring 202 to provide a selected capacitive coupling (based on the width 708 and spacing 710 of the ring 702 relative to the on-chip pad 104. The ring 202 may provide a signal path from the on-chip pad 104 and the one or more interconnects 204 to the wire trace 206. As indicated above, the number of interconnects 204 and the position of the one or more interconnects 204 relative to the wire trace 206 effects the resistance of the signal paths and contributes to the impedance compensation.

In some implementations, by combining a ring 202 that is coupled to the on-chip pad 104 by one or more interconnects 204 with a ring 702 that is capacitively coupled to the on-chip pad 104, the ring-based matching network 130 may provide a selected impedance compensation. While the example in FIG. 12 includes only one capacitively coupled ring 702, multiple rings 702 may be provided. Additionally, while the on-chip transition 1200 depicts only one interconnect 204, other configurations, such as those depicted in FIG. 4 may be used in conjunction with the one or more rings 702 to provide a selected impedance compensation.

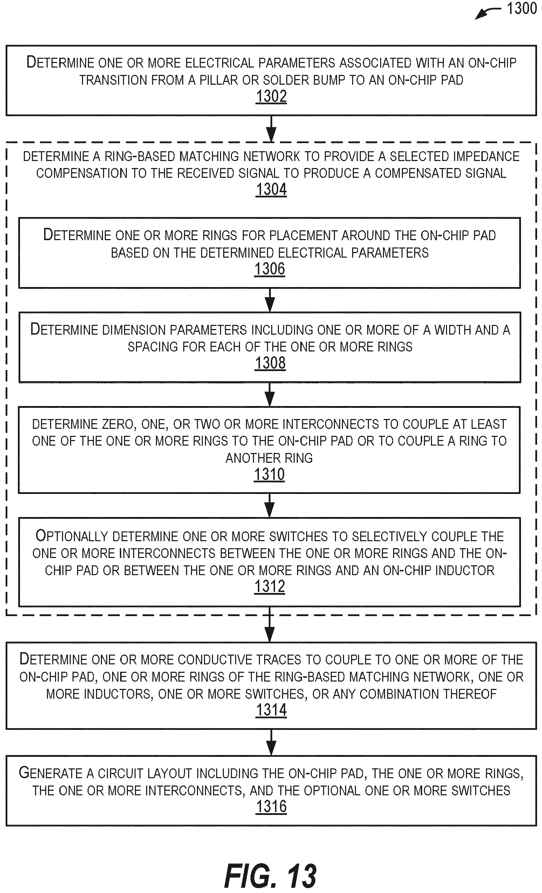

FIG. 13 depicts a flow diagram of an embodiment of a method 1300 of generating a ring-based matching network 130, in accordance with one or more embodiments of the present disclosure. At 1302, the method 1300 may include determining one or more electrical parameters associated with an on-chip transition 200 (FIGs. 2-6), 700 (FIGs. 7-11), or 1200 (FIG. 12) from a pillar (or solder bump) 102 to an on-chip pad 104. The on-chip transition may be configured to receive a signal from an external source, such as another chip, a wire trace, an antenna, or another source. The one or more electrical parameters may be determined through computer modeling, industrial testing, or other methods.

At 1304, the method may include determining a ring-based matching network 130 to provide a selected impedance compensation to signals received at the on-chip pad to produce a compensated signal. The ring-based matching network 130 may include any of the configurations described above with respect to FIGs. 2-12 or variations thereof.

In one or more embodiments, determining a ring-based matching network 130 may include determining one or more rings 202 or 702 for placement around the on-chip pad 104 based on the determined electrical parameters, at 1306. Based on a selected impedance compensation, the ring-based matching network 130 may be selected to have a selected number of rings and may be determined to include rings that are capacitively coupled to the on-chip pad 104, connected to the on-chip pad 104 by one or more interconnects 204, or any combination thereof.

At 1308, determining the ring-based matching network 130 may include determining one or more of a width 208,708 and a spacing 210, 710 for each of the one or more rings 202 or 702. The width 208, 708 and spacing 210, 710 of each ring 202, 702 may be the same or may be different.

At 1310, determining the ring-based matching network 130 may include determining zero, one, or two or more interconnects 204 to couple at least one of the one or more rings 202 to the on-chip pad 104 or to couple a ring 702 to another ring 702. Capacitively coupled rings 702 are not coupled by interconnects 204 to the on-chip pad 104, but may be coupled to one another by one or more interconnects 1104, depending on the embodiment.

At 1312, determining the ring-based matching network 130 may include optionally determining one or more switches to selectively couple the one or more interconnects between the on-chip pad 104 and the one or more rings 202 or between one or more of the rings 702 and an on-chip inductor 806. The switches may be implemented as MOSFETs 902.

At 1314, the method 1300 may include determining one or more conductive traces to couple to one or more of the on-chip pad 104, one or more rings 202 or 702 of the ring-based matching network 130, one or more inductors 806, one or more switches 602 or 902, or any combination thereof. In some embodiments, the conductive traces may include a wire trace 106 connected to the on-chip pad 104 and to the on-chip circuit, an interconnect 204 configured to connect a ring 202 to another ring, a wire trace 702 to couple a ring to one of a transistor 902 or an inductor 806,

At 1316, the method 1300 may include generating a circuit layout including the on-chip pad 104, the one or more rings 202 or 702, the one or more interconnects 204 or 1104, and the optional one or more switches (MOSFETs 902). As indicated above, the interconnects 204 may couple the on-chip pad 104 to a ring 202, while the interconnects 1104 may couple a capacitively coupled ring 702 to another ring 702.

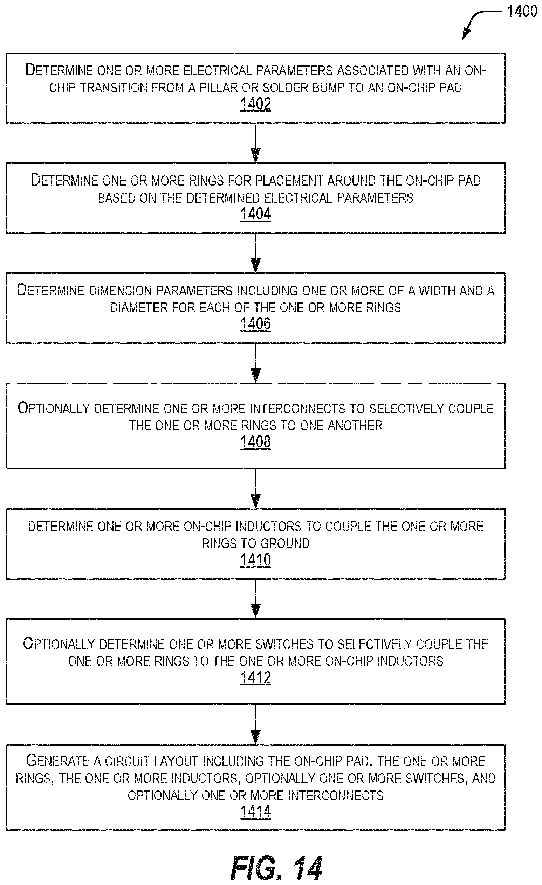

The example of the method 1300 of FIG. 13 may be used to generate the on-chip transition of any of the on-chip transitions depicted in FIGs. 2-12. With respect to FIG. 14 below, a method of providing a capacitive impedance compensation is described.

FIG. 14 depicts a flow diagram of an embodiment of method 1400 of generating a ring-based matching network 130 using one or more capacitively-coupled rings 702 with on-chip inductors 806, in accordance with one or more embodiments of the present disclosure. At 1402, the method 1400 may include determining one or more electrical parameters associated with an on-chip transition 200 (FIGs. 2-6), 700 (FIGs. 7-11), or 1200 (FIG. 12) from a pillar (or solder bump) 102 to an on-chip pad 104. The one or more electrical parameters may be determined through computer modeling, industrial testing, or other methods.

At 1404, the method 1400 may include determining one or more rings 702 for placement around the on-chip pad 104 based on the determined electrical parameters. Based on a selected impedance compensation, the ring-based matching network 130 may be selected to have a selected number of rings that are capacitively coupled to the on-chip pad 104.

At 1406, the method 1400 may include determining one or more of a width 708 and a spacing 710 for each of the one or more rings 702. The width 708 and spacing 710 of each ring 702 may be the same or may be different.

At 1408, the method 1400 may include determining zero, one, or two or more interconnects 1104 to couple one of the one or more rings 702 to another ring 702. The interconnects 1104 may provide a signal path to the inductor through the one or more rings 702, altering a resistance due to the resistance along the length of the signal path.

At 1410, the method 1400 may include determining one or more on-chip inductors 806 to couple the one or more rings 702 to ground 808 (or to a negative supply voltage (Vss)). In some embodiments, one or more interconnects 1104 may couple the rings 702 together, so a single on-chip inductor 806 may be coupled to one of the rings 702. In other embodiments, interconnects 1104 may be omitted, and each ring 702 may be associated with one of the inductors 806.

At 1412, the method 1400 may include optionally determining one or more switches to selectively couple each of the one or more rings 702 to one of the on-chip inductors 806. The switches may be implemented as MOSFETs 902.

At 1414, the method 1400 may include generating a circuit layout including the on-chip pad 104, the one or more rings 702, optionally one or more switches (MOSFETs 902), and optionally one or more interconnects 1104. As indicated above, the interconnects 1104 may couple a capacitively coupled ring 702 to another ring 702.

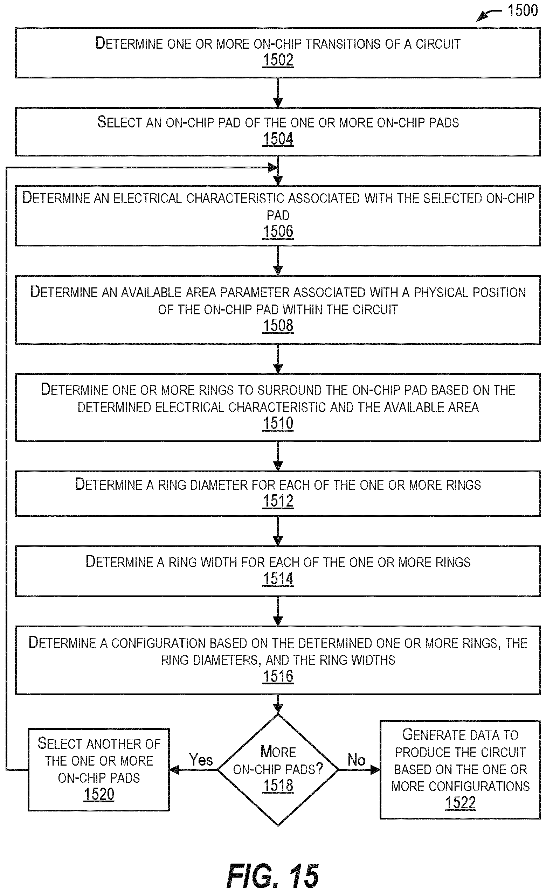

FIG. 15 depicts a flow diagram of an embodiment of a method 1500 of generating a ring-based matching network 130 for one or more on-chip transitions, in accordance with one or more embodiments of the present disclosure. At 1502, the method 1500 may include determining one or more on-chip transitions of a circuit. The circuit may have multiple on-chip transitions.

At 1504, the method 1500 may include selecting an on-chip pad 104 of the one or more on-chip pads. The method 1500 may iterate through each of the on-chip pads 104 until each on-chip pad 104 is selected and processed.

At 1506, the method 1500 may include determining an electrical characteristic associated with the selected on-chip pad 104. The electrical characteristic may include a characteristic impedance of the transition.

At 1508, the method 1500 may include determining an available area parameter associated with a physical position of the on-chip pad 104 within the circuit. Since circuit real estate can be limited, the available area near the on-chip transition may partially determine potential strategies for impedance compensation.

At 1510, the method 1500 may include determining one or more rings 202, 702 to surround the on-chip pad 104 based on the determined electrical characteristics and the available area. In some embodiments, one ring 202 or 702 may be used. In other embodiments, multiple rings 202, one or more rings 702, or any combination thereof may be used.

At 1512, the method 1500 may include determining a ring diameter for each of the one or more rings 202, 702. The ring diameter may define the spacing (d) 210, 710 for each ring. The ring diameter 710 may be same or different for each ring.

At 1514, the method 1500 may include determining a ring width for each of the one or more rings 202, 702. The ring width (w) 208, 708 may be the same or different for each ring.

At 1516, the method 1500 may include determining a configuration based on the determined one or more rings, the ring diameters, and the ring widths. The configuration may be any one of the configurations shown and described with respect to FIGs. 2-12 or variations thereof.

At 1518, if there are more on-chip pads 104 to be determined, the method 1500 may include selecting another of the one or more on-chip pads, at 1520. The method 1500 may then return to 1506 to determine an electrical characteristic associated with the selected on-chip pad 104.

Otherwise, at 1518, if there are no more on-chip pads 104 to be determined, the method 1500 may include generating data to produce the circuit based on the one or more configurations, at 1522. The data may include circuit layout data, such as schematic data, the physical/layout design of the integrated circuit, graphic design system II (GDSII) data, or other data for producing an integrated circuit including one or more ring-based matching networks 130.

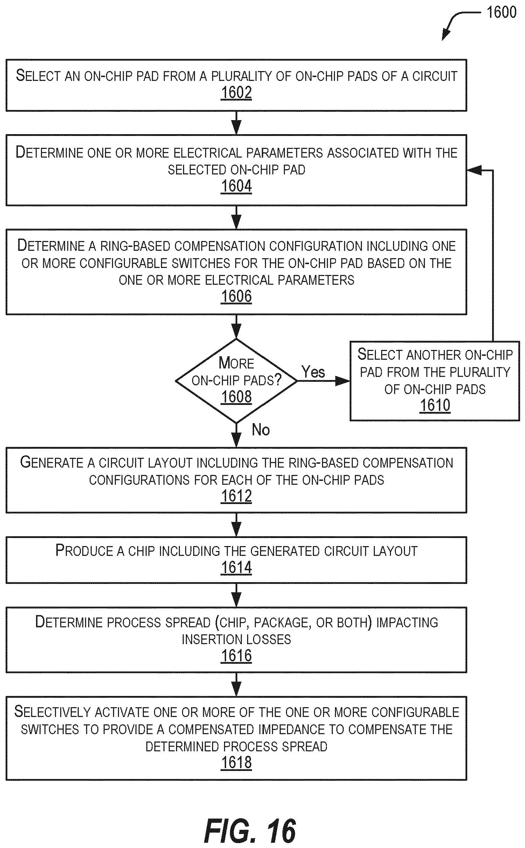

FIG. 16 depicts a flow diagram of a method 1600 of programming a ring-based matching network 130 by selectively activating one or more switches (MOSFETS 902), in accordance with one or more embodiments of the present disclosure. At 1602, the method 1600 may include selecting an on-chip pad from a plurality of on-chip pads of a circuit.

At 1604, the method 1600 may include determining one or more electrical parameters associated with the on-chip pad 104. The one or more electrical parameters may include the characteristic impedance of the on-chip transition from the pillar 102 or solder bump to the on-chip pad 104.

At 1606, the method 1600 may include determining a ring-based compensation configuration including one or more configurable switches for the on-chip pad 104 based on the one or more electrical parameters. The ring-based compensation configuration may include any of the embodiments described above with respect to FIGs. 2-12.

At 1608, if there are more on-chip pads, the method 1600 may include selecting another on-chip pad 104 from the plurality of on-chip pads 104, at 1610. In an example, a circuit design may include multiple on-chip pads 104 for coupling to other circuitry. After selecting another on-chip pad 104 at 1608, the method 1600 may then return to 1604 and may include determining one or more electrical parameters associated with the on-chip pad.

Otherwise, at 1608, if there are no more on-chip pads 104 to be processed, the method 1600 may include generating a circuit layout including the ring-based compensation configurations for each of the on-chip pads, at 1612. In some embodiments, a circuit may include multiple on-chip transitions, each with a selected ring-based compensation configuration. In some embodiments, the ring-based compensation configurations may be the same for each on-chip transition. In some embodiments, the ring-based compensation configurations may be different for each on-chip transition in terms of the number of rings 202 or 702, the inclusion or omission of interconnects 204 or 1104, the position of the interconnects 202 or 1104, the width 208 or 708 of the rings 202 or 702, the spacing 210 or 710 of the rings, other parameters, or any combination thereof.

At 1614, the method 1600 may include producing a chip including the generated circuit layout. The chip may be produced, for example, by building up metal and dielectric layers on a semiconductor substrate to form a semiconductor wafer and then cutting (singulating) the semiconductor wafer into die or chips.

At 1616, the method 1600 may include determining process spread (chip, packing, or both) impacting insertion losses. In some embodiments, the process spread may be determined during electrical testing prior to packaging the chip. The process spread may represent deviation between the circuit specification and the manufactured chip.

At 1618, the method 1600 may include selectively activating one or more of the one or more configurable switches to provide a compensated impedance to compensate the determined process spread. In some implementations, a control circuit 606 may apply a control signal to one or more selected transistors 602 or 902 to close a signal path. In some embodiments, one or more selected transistors 602 may be activated to couple the ring 202 to the on-chip pad 104, providing selected interconnects 204. In some embodiments, one or more selected transistors 902 may be activated to couple one or more rings 702 to one or more inductors 606. In other embodiments, one or more transistors may be activated to couple a ring 702 to another ring 702. In still other embodiments, a capacitive coupling with a ring 702 may be combined with a ring 202 that is connected to the on-chip pad 104 by one or more interconnects 204 to provide a selected impedance compensation.

It should be understood that the flow diagrams presented in FIGs. 13-16 are illustrative only and are not intended to be limiting. Blocks indicating steps in the flow diagrams may be omitted or added and the order of the blocks may be changed without departing from the scope of the disclosure.

In some embodiments, an electronic device may include a semiconductor wafer including a semiconductor substrate and multiple layers on the semiconductor substrate. The multiple layers may include metal layers and dielectric layers forming a circuit and an on-chip pad configured to receive a signal. The electronic device may include a ring-based matching network including one or more rings arranged within the multiple layers and extending around the on-chip pad to provide a selected impedance compensation to the received signal to produce a compensated signal. Each ring may have a selected width and a selected spacing relative to one or more of the on-chip pad or another ring. The electronic device may include a wire trace configured to couple the on-chip pad to the circuit to provide the compensated signal.

In some embodiments, the one or more rings may include a first ring having a first spacing relative to the on-chip pad and having a first width and a second ring having a second spacing relative to the first ring and having a second width. In some embodiments, the first width and the second width may be approximately the same. In some embodiments, the first spacing and the second spacing may be approximately the same. In some embodiments, the first and second widths may be different. In some embodiments, the first and second spacings may be different. In some embodiments, the first spacing is greater than the second spacing or vice versa. In some embodiments, the first width is greater than the second width or vice versa.

In one or more embodiments, the ring-based matching network 130 may include one or more interconnects 204 configured to couple the one or more rings 202 to the on-chip pad 104, and the wire trace 206 may be coupled to one of the one or more rings 202 and to the circuit.

In one or more embodiments, the ring-based matching network 130 may include a plurality of switches (MOSFETs 604). Each MOSFET (switch) 604 may include a first terminal coupled to the on-chip pad 104, a second terminal coupled to one of the one or more rings 202, and a control input. The electronic device may include a control circuit coupled to the control input of each of the plurality of switches (MOSFETS 604). The control circuit may be configured to selectively activate one or more of the switches (MOSFETs 604) to couple the one of the one or more rings 202 to the on-chip pad 104 to provide a selected impedance compensation.

In one or more embodiments, the ring-based matching network 130 comprises one or more inductors 806. Each inductor 806 may include a first terminal coupled to one of the one or more wire traces 702 and a second terminal coupled to one of a negative supply voltage (VSS) or ground 808. In some embodiments, the ring-based matching network 130 may include one or more MOSFETs 902 (or switches). Each MOSFET 902 may include a first terminal coupled to one of the one or more rings 702, a second terminal coupled to an inductor 806, and a control terminal. The electronic device may include control circuitry 606 coupled to each of the control terminals and configured to selectively activate one or more of the MOSFETs 902 to provide a selected impedance compensation.

In some embodiments, the ring-based matching network 130 may include one or more interconnects 204. Each interconnect 204 may be configured to connect a first ring 202(1) of the one or more rings to a second ring 202(2) of the one or more rings to provide a signal path from the first ring 202(1) to the second ring 202(2).

In some embodiments, a method of providing impedance compensation may include determining one or more electrical parameters associated with an on-chip transition of a circuit. The on-chip transition may include an on-chip pad 104 configured to receive a signal. The method may include determining a ring-based matching network 130 to provide a selected impedance compensation to the received signal 108 to produce a compensated signal 212. The ring-based matching network 130 including one or more rings around the on-chip pad. The method may include determining one or more conductive traces 106 or 206 to couple one or more of the on-chip pad 104 or the ring-based matching network 130 to the circuit. The method may include producing a semiconductor chip including the circuit, the on-chip transition 104, the ring-based matching network 130 and the one or more conductive traces 106 or 206.

In some embodiments, determining the ring-based matching network may include determining at least one of the one or more rings 202 or 702 to be formed around the on-chip pad 104 based on the determined one or more electrical parameters. In some embodiments, determining the ring-based matching network 130 may include determining dimension parameters including one or more of a width 208 or 708 and a spacing 210 or 710 for each of the one or more rings 202 or 702. In some embodiments, determining the ring-based matching network 130 may include determining one or more interconnects 1104 to couple a first ring of the one or more rings 702(1) to a second ring 702(2) of the one or more rings.

In some embodiments, determining the ring-based matching network 130 may include determining one or more conductive traces (or interconnects) 204 to couple the on-chip pad 104 to one of the one or more rings 202. In some embodiments, determining the ring-based matching network 130 may include determining one or more switches (MOSFETs 604) to selectively couple the one or more interconnects 204 between first and second rings 702(1) and 702(2) of the one or more rings 702, between one of the rings and the on-chip pad 204, or between one or more of the one or more rings and an on-chip inductor 704. In some embodiments, the method may include determining one or more conductive traces 106 or 206 to couple one or more of the on-chip pad 104 or one of the one or more rings 202 to an on-chip circuit.

In one or more embodiments, an electronic device may include a semiconductor wafer including a semiconductor substrate 222 and multiple layers including metal layers 226 and dielectric layers 228 on the semiconductor substrate 222 forming a circuit and an on-chip pad 104 configured to receive a signal 108. The electronic device may include a ring-based matching network 130 including one or more rings 202 or 702 arranged within the multiple layers and extending around the on-chip pad 104 to provide a selected impedance compensation to the received signal 108 to produce a compensated signal 212. Each ring 202 or 702 may have a selected width 208 or 708 and a selected spacing 210 or 710 relative to one or more of the on-chip pad 104 or another ring. The electronic device may include a wire trace 106 or 206 configured to couple the on-chip pad 104 to the circuit to provide the compensated signal 212.

In some embodiments, the electronic device may include a plurality of transistors. Each transistor 602 may include a first terminal coupled to the on-chip pad 104 at a selected location about a peripheral edge of the on-chip pad 104, a second terminal coupled to a ring 202 of the one or more rings, and a control terminal. The electronic device may include control circuitry 606 coupled to the control terminal of each of the plurality of transistors 602. The control circuitry 606 may be configured to selectively activate one or more of the plurality of transistors 206 to connect the on-chip pad 104 to the ring 202. The wire trace 206 may include a first end connected to the ring 202 and a second end coupled to the circuit.

In some embodiments, the electronic device may include one or more inductors 806. Each inductor 806 may include a first terminal and a second terminal. The second terminal may be coupled to one of a negative power supply (VSS) or ground. The electronic device may include one or more transistors 902. Each transistor 902 may include a first terminal coupled to a ring 702 of the one or more rings, a second terminal coupled to one of the one or more inductors 806, and a control terminal. The electronic device may include control circuitry 606, which may be coupled to the control terminal of each of the one or more transistors 806. The control circuitry may be configured to selectively activate one or more of the one or more transistors 902 to selectively connect the one or more rings 702 to the one or more inductors 806. The one or more rings 702 may be capacitively coupled to the on-chip pad 104 and the wire trace 106 may include a first end connected to the on-chip pad 104 and a second end coupled to the circuit.

In some embodiments, the one or more rings 202 or 702 may include a first ring having a first spacing 210(1) relative to the on-chip pad 104 and having a first width 208(1) and may include a second ring having a second spacing 210(2) relative to the first ring and having a second width 208(2). In some embodiments, the first spacing 210(1) or 710(1) is different from the second spacing 210(2) or 710(2). The first width 208(1) may be the same as (equal to) or different from (greater than or less than) the second width 708(2).

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. An electronic device comprising:
a semiconductor wafer including a semiconductor substrate and multiple layers on the semiconductor substrate, the multiple layers including metal layers and dielectric layers forming a circuit and an on-chip pad configured to receive a signal;
a ring-based matching network including one or more rings arranged within the multiple layers and extending around the on-chip pad to provide a selected impedance compensation to the received signal to produce a compensated signal, each ring having a selected width and a selected spacing relative to one or more of the on-chip pad or another ring; and
a wire trace configured to couple the on-chip pad to the circuit to provide the compensated signal.

2. The electronic device of claim 1, wherein the one or more rings comprises:
a first ring having a first spacing relative to the on-chip pad and having a first width; and
a second ring having a second spacing relative to the first ring and having a second width.

3. The electronic device of claim 2, wherein the first spacing is greater than the second spacing.

4. The electronic device of claim 2 or 3, wherein the first width is greater than the second width.

5. The electronic device of any one of claims 1 to 4, wherein the ring-based matching network comprises:
one or more interconnects configured to couple the one or more rings to the on-chip pad; and
wherein the wire trace is coupled to one of the one or more rings and to the circuit.

6. The electronic device of any one of claims 1 to 5, wherein the ring-based matching network comprises:
a plurality of switches, each switch including a first terminal coupled to the on-chip pad, a second terminal coupled to one of the one or more rings, and a control input; and
a control circuit coupled to the control input of each of the plurality of switches, the control circuit configured to selectively activate one or more of the switches to couple the one of the one or more rings to the on-chip pad to provide a selected impedance compensation.

7. The electronic device of any one of claims 1 to 6, wherein the ring-based matching network comprises one or more inductors, each inductor including a first terminal coupled to one of the one or more wire traces and a second terminal coupled to one of a negative supply voltage (VSS) or ground.

8. The electronic device of any one of claims 1 to 7, wherein the ring-based matching network comprises one or more interconnects, each interconnect configured to connect a first ring of the one or more rings to a second ring of the one or more rings to provide a signal path from the first ring to the second ring.

9. A method of providing impedance compensation, the method comprising:
determining one or more electrical parameters associated with an on-chip transition of a circuit, the on-chip transition including an on-chip pad configured to receive a signal;
determining a ring-based matching network to provide a selected impedance compensation to the received signal to produce a compensated signal, the ring-based matching network including one or more rings around the on-chip pad;
determining one or more conductive traces to couple one or more of the on-chip pad or the ring-based matching network to the circuit; and
producing a semiconductor chip including the circuit, the on-chip transition, the ring-based matching network and the one or more conductive traces.

10. The method of claim 9, wherein determining the ring-based matching network comprises determining at least one of the one or more rings to be formed around the on-chip pad based on the determined one or more electrical parameters.

11. The method of claim 9 or 10, wherein determining the ring-based matching network comprises determining dimension parameters including one or more of a width and a spacing for each of the one or more rings.

12. The method of any one of claims 9 to 11, wherein determining the ring-based matching network comprises determining one or more interconnects to couple a first ring of the one or more rings to a second ring of the one or more rings.

13. The method of any one of claims 9 to 12, wherein determining the ring-based matching network comprises determining one or more interconnects to couple the on-chip pad to one of the one or more rings.

14. The method of any one of claims 9 to 13, wherein determining the ring-based matching network comprises determining one or more switches to selectively couple the one or more conductive traces between first and second rings of the one or more rings, between one of the one or more rings and the on-chip pad, or between one or more of the one or more rings and an on-chip inductor.

15. The method of any one of claims 9 to 14, further comprising determining one or more conductive traces to couple one or more of the on-chip pad or one of the one or more rings to an on-chip circuit.
